# EUROPEAN PATENT SPECIFICATION

(11) **EP 3 073 320 B1**
(45) Date of publication and mention of the grant of the patent: **26.08.2020**
(21) Application number: 16161477.1
(22) Date of filing: 21.03.2016
(51) Int. Cl.: G03F 7/00, B32B 5/32, G03F 7/027, G03F 7/038, G03F 7/11, G03F 7/09

(54) **LAMINATED FILM**
VERBUNDFOLIE
FILM STRATIFIÉ

(30) Priority: 26.03.2015 JP 2015063996
(43) Date of publication of application: 28.09.2016
(73) Proprietor: TOKYO OHKA KOGYO CO., LTD., Kawasaki-shi, Kanagawa 211 (JP)
(72) Inventor: SENZAKI, Takahiro, KANAGAWA 211-0012 (JP); NOGUCHI, Takuya, KANAGAWA 211-0012 (JP); SUZUKI, Yasuo, KANAGAWA 211-0012 (JP); OGATA, Toshiyuki, KANAGAWA 211-0012 (JP)
(74) Representative: Plasseraud IP

(56) References cited:
- EP-A1- 1 666 129
- EP-A1- 2 977 099
- WO-A1-2013/043124
- WO-A1-2013/049936

## Description

### BACKGROUND OF THE INVENTION

### Field of the Invention

The present invention relates to a laminated film.

### Related Art

In recent years, self-standing thin films having a large surface area, a thickness on a nanometer order, and a permeability high enough to allow microsubstances to be passed therethrough have attracted attention as usable, for example, as permselective membranes, microsensors and drug delivery films. For this reason, various studies have been made on methods for manufacturing permeable self-standing thin films, and examples of manufacturing methods known in the art include water surface casting methods and interface reaction methods using silane coupling agents. The thin films obtained by these methods, however, generally suffer from problems such as poor mechanical strength, difficulties in increasing the area of the thin film, and limitation of the accuracy of the thin film.

Polymer thin films that are manufactured by a method described in Patent Document 1 and self-supporting even in a thickness of not more than 100 nm, and the polymer thin films are known as self-standing films. In the method described in Patent Document 1, polymer thin films are manufactured by providing a sacrificial layer on a surface of a support, subjecting a polymerizable compound in a composition to chain polymerization on the surface of the sacrificial layer, and then removing the sacrificial layer to separate the polymerized composition from the support.

Patent Document 1: Japanese Unexamined Patent Application, Publication No. 2008-285617
WO 2013/043124 A1 relates to multilayer filter.
EP 2 977 099 A1 relates to a membrane filter made of photosensitive material.
EP 1 666 129 A1 relates to a composite porous membrane.

### SUMMARY OF THE INVENTION

Certainly, thin films manufactured by the method described in Patent Document 1 are self-standable even when the thickness is very small and not more than 100 nm. A problem of strength involved in the thin films on a nanometer order remains still unsolved.

Further, since thin films manufactured by the method described in Patent Document 1 are nonporous, gases having a small molecular size may be passed well through the films, whereas gases having a large molecular size and a liquid cannot be sometimes filtered or a long period of time is necessary for filtration. In some cases, the filtration capability can be improved by providing a difference in pressure between both sides of the membrane during the filtration. The application of pressure to thin films manufactured by the method described in Patent Document 1 is likely to cause breaking of the thin films.

An object of the present invention is to provide a laminated film that has the strength high enough to withstand the pressure applied during filtration without breaking and a good filtration rate and is usable as filters.

The present inventors have found that, for a laminated film comprising a thin film and a support film stacked on top of each other, the thin film having a thickness of 1 nm to 1 µm and including a first pore portion having one or more pores, the support film having a thickness of 1 to 100 µm and including a second pore portion having one or more pores, the above problem can be solved by satisfying the requirements that the pores of the thin film have an average aspect ratio of not more than 2, the thin film has an opening ratio of not more than 80%, and the first pore portion in the thin film is disposed so as to meet a predetermined relationship with the second pore portion in the support film. This has led to the completion of the present invention.

Specifically, the present invention relates to a laminated film comprising a thin film and a support film stacked on top of each other, wherein
the thin film comprises a first pore portion having one or more pores that extend through the thin film in a thickness direction,
the support film comprises a second pore portion having one or more pores that extend through the support film in a thickness direction,
at least a part of the pores constituting the first pore portion is in communication with at least a part of the pores constituting the second pore portion,
the thin film has a thickness of 1 nm to 1 µm,
the thin film has an opening ratio of not more than 80%,
the pore in the thin film has an aspect ratio A/B of not more than 2 wherein A represents a thickness of the thin film; and B represents an average value of the width of the openings in the one or more pores possessed by the thin film, and
the support film has a thickness of 1 to 100 µm, and all the openings of the pores constituting the first pore portion are included respectively within the openings of the pores constituting the second pore portion.

The present invention can provide a laminated film that simultaneously has the strength high enough to withstand the pressure applied during filtration and a good filtration rate and that is usable as filters.

### BRIEF DESCRIPTION OF THE DRAWINGS

Fig. 1 is a typical view of a section perpendicular to a surface direction of a laminated film according to the present invention.
Fig. 2A is a typical sectional view of a substrate with an antireflection film provided thereon.
Fig. 2B is a typical sectional view of a substrate with an antireflection film and a sacrificial film provided thereon.
Fig. 2C is a typical sectional view of a substrate with an antireflection film, a sacrificial film, and a precursor film for a thin film provided thereon.
Fig. 2D is a typical view illustrating position-selective exposure of a precursor film for a thin film in a substrate with an antireflection film, a sacrificial film, and a precursor film for a thin film provided thereon.
Fig. 2E is a typical view illustrating development of an exposed precursor film for a thin film with a developing solution in a substrate with an antireflection film, a sacrificial film, and a position-selectively exposed precursor film for a thin film provided thereon.
Fig. 2F is a typical sectional view of a substrate with an antireflection film, a sacrificial film, and a thin film containing a first pore portion provided thereon.
Fig. 2G is a typical sectional view of a substrate with an antireflection film, a sacrificial film, a film containing a first pore portion, and a precursor film for a support film provided thereon.
Fig. 2H is a typical view illustrating position-selective exposure of a precursor for a support film in a substrate with an antireflection film, a sacrificial film, a thin film containing a first portion, and a precursor film for a support film provided thereon.
Fig. 2I is a typical view of development of an exposed precursor film for a support film with a developing solution in a substrate with an antireflection film, a sacrificial film, a thin film containing a first pore portion, and a position-selectively exposed precursor film for a support film provided thereon.
Fig. 2J is a typical sectional view of a substrate with an antireflection film, a sacrificial film, a thin film containing a first pore portion, and a support film containing a second pore portion provided thereon.
Fig. 2K is a typical view illustrating the separation of a laminated film comprising a thin film containing a first pore portion and a support film containing a second pore portion from a substrate by dissolving a sacrificial film.

### DETAILED DESCRIPTION OF THE INVENTION

### <<Laminated film>>

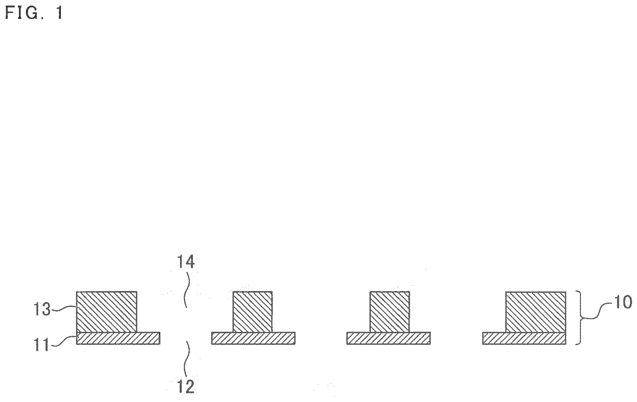

The laminated film according to the present invention will be described with reference to Fig. 1. Fig. 1 is a typical view of a section perpendicular to a surface direction of a laminated film 10.

At the outset, a laminated film 10 according to the present invention is a film comprising a thin film 11 and a support film 13 stacked on top of each other.

The thin film 11 comprises a first pore portion 12 having one or more pores that extend through the thin film 11 in a thickness direction.

Further, the support film 13 comprises a second pore portion 14 having one or more pores that extend through the support film 13 in a thickness direction.

The first pore portion 12 and the second pore portion 14 are arranged respectively in the thin film 11 and the support film 13 so that, when the thin film 11 and the support film 13 are stacked on top of each other, at least a part of one or more pores constituting the first pore portion 12 comes into communication with at least a part of one or more portions constituting the second pore portion 14.

This can allow a fluid such as a liquid or gas to be passed well through the laminated film 10.

For example, when the shape of the opening in the first pore portion 12 and the shape of the opening in the second pore portion 14 are circular, preferably, the first pore portion 12 and the second pore portion 14 are arranged so that an inner circle formed of an outer edge of the opening of the first pore portion is completely included in the inside of an outer circle formed of an outer edge of the opening in the second pore portion 14.

When the first pore portion 12 and the second pore portion 14 are arranged in this way, through-pores formed of the first pore portion 12 and the second pore portion 14 that extend through the laminated film 10 in a thickness direction are formed, and, at the same time, substances having a smaller diameter than the diameter of openings in the first pore portion 12 can be selectively passed through the laminated film 10.

In this case, when the laminated film 10 is observed in a direction perpendicular to a surface direction, the proportion of the total of areas of openings in the first pore portion 12 overlapped with openings in the second pore portion 14 to the total area of the openings in the first pore portion 12 is preferably not less than 50%, more preferably not less than 70%, particularly preferably not less than 90%, most preferably 100%.

That is, the first pore portion 12 and the second pore portion 14 are arranged so that all the openings in the pores constituting the first pore portion 12 are included respectively within the openings in the pores constituting the second pore portion 14. In this case, a plurality of, i.e., two or more pores constituting the first pore portion may be included within the opening in one pore in the second pore portion 14.

In the laminated film 10, when the first pore portion 12 including a plurality of pores having circular openings and the second pore portion 14 including a plurality of pores having circular openings are arranged as described above, in general, the average opening diameter of the second pore portion 14 is larger than the average opening diameter of the first pore portion 12. Accordingly, among microparticles contained in a fluid that is a filtration object, particles having a larger diameter than the average opening diameter of the first pore portion 12 cannot be passed through the laminated film 10.

Another example of the arrangement will be described. When the first pore portion 12 comprises a plurality of pores having linear openings arranged parallel to each other in the thin film 11 and the second pore portion 14 comprises a plurality of pores having circular openings, the first pore portion 12 and the second pore portion 14 may be arranged so that, when the laminated film 10 is observed in a direction perpendicular to a surface direction, linear pores constituting the first pore portion 12 are partially observed within the openings in the second pore portion 14.

On the other hand, for example, very thin polymeric thin films, woven fabrics or nonwoven fabrics of ultrafine fibers, and sponge-shaped porous thin films have hitherto been known as thin films that allow fluids such as gases and liquids to be passed through the thin films in a thickness direction thereof.

When a fluid is passed through these thin films, the fluid is moved through the thin films in an irregular direction. Specifically, in very thin polymeric thin films, a fluid is passed through microgaps produced between polymer molecular chains in an irregular direction. In woven fabrics or nonwoven fabrics of ultrafine fibers, a fluid is passed through microgaps produced between fibers in an irregular direction. In sponge-shaped porous thin films, a fluid is passed in an irregular direction through spaces formed by small bubble-shaped gaps that are contained in the thin film and are continued to each other.

Further, paths through which the fluid in these thin films is passed are uneven in diameter, and, thus, the fluid passed through the thin film causes turbulent flow.

Further, when the fluid to be passed through the thin film contains very small solid particles, in the very thin polymeric thin film, the passage of the solid particles is difficult, while, in the woven fabric or nonwoven fabric of ultrafine fibers and the sponge-shaped porous thin film, clogging of paths through which the fluid is passed with the solid particles is likely to occur, and, thus, a very long period of time is sometimes necessary for the filtration.

For this reason, when very thin polymeric thin films, woven fabrics or nonwoven fabrics of ultrafine fibers, sponge-shaped porous thin films and the like are used as membrane filters, the filtration resistance is likely to be high. When the filtration resistance is high, in some cases, a very long period of time is necessary for the filtration. The filtration rate can be increased by enhancing the filtration pressure. When the filtration is carried out at a high pressure, damage to the membrane filter is likely to occur.

By contrast, the laminated film 10 according to the present invention comprises a first pore portion 12 and a second pore portion 14 and has through-pores that extend through the laminated film 10 linearly or substantially linearly in a thickness direction thereof, and, thus, gases or liquids after the filtration are passed through the laminated film 10 at the shortest distance. Accordingly, the laminated film 10 according to the present invention has a low filtration resistance and, thus, can realize a high filtration rate.

The thin film 11 and the support film 13 constituting the laminated film 10 will be described below.

### [Thin film]

The thickness of the thin film 11 is 1 nm to 1 µm. The opening ratio of the thin film 11 is not more than 80%, and the aspect ratio, which will be defined later, of the first pore portion 12 in the thin film 11 is not more than 2. The lower limit of the aspect ratio of the first pore portion 12 is not particularly limited as long as the object of the present invention is not sacrificed but is, for example, not less than 0.01 and may be not less than 0.1.

Here the aspect ratio of the first pore portion 12 is the ratio of A to B, that is, a ratio A/B.
A: thickness of the thin film 11.
B: average of openings in one or more pores contained in the first pore portion 12.

In the following diameter 1 and diameter 2, a smaller value is regarded as an opening width of pores contained in the first pore portion 12.
(Diameter 1) Minor axis in Feret diameters. The Feret diameter is the length of a side of a rectangle or a square having a minimum area in rectangles or squares by which the outer periphery of openings in the pores is circumscribed. When the shape of the opening is circular, the diameter of the circle is diameter 1, while, when the shape of the opening is square, the length of a side of the square is diameter 1.
(Diameter 2) Line width when the shape of the opening in the pore is linear.

For example, a pore having a linear opening that has a shape formed by folding a rectangle having a width of 10 nm and a length of 50 nm at a position of 25 nm from the end of the rectangle so that both the ends overlap with each other will be reviewed. In this case, the Feret diameter is approximately 20 nm (10 nm in width + 10 nm in width) and 25nm (50 nm in length ÷ 2). Accordingly, the minor axis in the Feret diameters is about 20 nm. On the other hand, the line width is 10 nm.

Thus, in this case, a size of 10 nm is adopted as the opening width of the pores.

When the shape of the openings in the pores is linear, the line width is preferably even or substantially even.

For example, for a thin film 11 that has a first pore portion 12 including a plurality of pores having circular openings with a diameter of 1 µm and has a thickness of 1 µm, the aspect ratio is 1 (1 µm/1 µm).

Further, also for a thin film 11 that has a first pore portion 12 including a plurality of pores having linear openings with a line width of 1 µm and has a thickness of 1 µm, the aspect ratio is 1 (1 µm/1 µm).

In order to realize a good filtration rate while ensuring membrane strength, a somewhat thick membrane with a thickness of more than 1 µm and a high opening ratio of more than 90% are required of porous membranes that have hitherto been used as filters.

When the thin film 11 is a thin film and has the first pore portion 12, the fluid as the filtration object is passed through the thin film 11 in a very short period of time. Accordingly, in the thin film 11, a good filtration rate can be ensured even when the opening ratio is set to a low value of not more than 80%.

Further, strength high enough to withstand pressure applied during filtration is required of porous membranes used as filters. Thin films generally have poor pressure resistance. Since, however, the thin film 11 has a low opening ratio of not more than 80% and the average aspect ratio of the first pore portion 12 is low and not more than 2, the thin film 11 has good pressure resistance despite of the small thickness.

Further, since the thin film 11 has a small thickness of 1 nm to 1 µm and the aspect ratio is low, the film 11 can allow a fluid as a filtration object to be passed well therethrough despite of a low opening ratio of not more than 80%.

Thus, the laminated film 10 comprising the thin film 11 can simultaneously realizes strength high enough to withstand pressure applied during filtration without breaking and a good filtration rate.

The shape of the openings in the surface of the thin film 11 corresponding to both ends of the pores constituting the first pore portion 12 is not particularly limited. When the first pore portion 12 comprises a plurality of pores, examples of shapes of openings of the pores include polygons such as triangles (for example, regular triangle), quadrangles (for example, square), and hexagons (for example, regular hexagon), circles and ellipses. The shape of the opening is preferably circular, because the passage of substances having a desired size is less likely to be inhibited and the passage of substances having a larger size than the desired size can easily be inhibited. Any shape that can be visually recognized as the above regular triangles, square, regular hexagons, circles, ellipses and the like may be adopted, and the shape of the opening is not limited to these geometrically defined shapes.

Further, the shape of the opening in the surface of the thin film 11 may be in the form of a line having a desired width. The shape of the opening may be in the form of an unbranched line or a branched line. The number of pores having a linear opening constituting the first pore portion 12 may be one or at least two.

When the first pore portion 12 comprises one pore having a linear opening, examples of the shape of the opening include serpentine lines, comb-shaped lines, lines that are radially extended from a substantially central portion in a surface having openings in the thin film 11, and a spiral line that starts at a nearly central portion of a surface having openings in the thin film 11.

When the first pore portion 12 comprises a plurality of pores having linear openings, the shape of openings in the plurality of pores may be in the form of a straight line, a curved line, or a wavy line. In this case, since the strength of the thin film 11 is even regardless of the position, preferably, a plurality of pores are provided so that a plurality of linear openings having an identical shape are arranged parallel to each other.

The first pore portion 12 may contain pores with openings having two or more different shapes, or alternatively may contain pores with openings having two or more different sizes.

As described above, the value of B defined as an average value of widths of the opening contained in the first pore portion is not particularly limited as long as the first pore portion 12 and the second pore portion 14 are arranged so as to meet the above relationship and, at the same time, the opening ratio of the thin film 11 and the average aspect ratio of the first pore portion 12 falls within respective predetermined ranges.

The value of B in the thin film 11 is properly set depending upon the diameter of solid particles to be removed from the fluid. The value of B is preferably, for example, not more than 1 µm because solid particles that are generally desired to be removed can be removed well.

Further, the lower limit of the value of B is preferably not less than 1 nm, more preferably not less than 10 nm, particularly preferably not less than 100 nm, for example, from the viewpoint of filtration rate.

When the value of B in the thin film 11 is not more than 1 µm, preferably, the thin film 11 opening ratio and the aspect ratio of the first pore portion 12 are not more than 40% and not more than 1, respectively, from the viewpoint of a balance between the filtration rate and the strength of the laminated film 10.

As described above, the thin film 11 comprises a first pore portion 12 having one or more pores that extend through the thin film 11 in a thickness direction. Any method for the formation of the first pore portion 12 in the thin film 11 may be used without particular limitation.

A method in which a thin film formed from a photosensitive composition is position-selectively exposed and then developed to form through-pores in a thin film 11 may be mentioned as a method suitable for the formation of a first pore portion 12 in the thin film 11. According to this method, through-pores with the shape and diameter of openings being closely regulated can be formed by the use of a photomask. Photosensitive compositions are divided into positive-type photosensitive compositions that allow exposed areas to be rendered soluble in developing solutions and negative-type photosensitive compositions that allow exposed areas to be rendered insoluble in developing solutions. Both the types may be used in the formation of the thin film.

A method in which through-pores are formed by a photonanoimprinting method using a mold having convexes having a predetermined shape in a precursor film for a thin film 11, the precursor film being formed of a photosensitive composition for photonanoimprinting, may be mentioned as another method suitable for the formation of a first portion 12 in a thin film 11. Specifically, a photosensitive composition for photonanoprinting is coated on a substrate to form a precursor film for a thin film 11, a mold having convexes having a shape corresponding to through-holes is pressed against the precursor film to deform the precursor film and thus to form an uncured thin film 11, the uncured thin film 11 is then exposed for curing, and the mold is then separated from the thin film 11. Examples of suitable photosensitive compositions for photonanoimprinting may include a composition comprising a siloxane resin containing a photopolymerizable sensitive group such as a functional group containing an ethylenically unsaturated bond and a photopolymerization initiator, and a composition comprising an acrylic resin containing a photopolymerizable functional group such as a functional group containing an ethylenically unsaturated bond and a photopolymerization initiator. The photosensitive composition for photonanoprinting may contain an alkoxysilane compound.

The first pore portion 12 can also be formed in the thin film 11 by a thermal imprinting method. In the thermal imprinting method, a mold that has convexes having a shape corresponding to through-pores constituting a first pore portion 12 and has been heated to a glass transition temperature or above is pressed against a precursor film for a thin film 11, the precursor film being formed of a material having a glass transition temperature, to deform the precursor film, and the deformed precursor film is cooled to produce a thin film 11 comprising a first pore portion 12.

Examples of materials applicable to the thermal imprinting method include resins, glass, and metals. Among them, resins are preferred because thermal imprinting at low temperatures is possible.

In the formation of the thin film 11 by the thermal imprinting method, examples of resins usable as materials for the precursor film for the thin film 11 include (meth)acrylic resins typified by polymethacrylic acid (PMMA), polycarbonate resins, polystyrene, polyester resins such as polyethylene terephthalate, and thermoplastic resins such as cyclic olefins.

Further, a thin film 11 having a first pore portion 12 can be formed by a pattern formation method utilizing a microphase separation phenomenon that allows a polymer block copolymer to form regular domains of nanosize, as described, for example, in Japanese Unexamined Patent Application, Publication No. 2008-036491 and Japanese Unexamined Patent Application, Publication No. 2014-099568.

A method in which fine particles having a particle diameter similar to the thickness of a thin film 11 in the thin film 11 may be mentioned as another method.

Any method for the removal of fine particles from the thin film 11 may be used without particular limitation. When the material for fine particles is a heat decomposable or sublimable substance, fine particles can be removed from inside the thin film by heating the thin film. Further, fine particles can also be removed from the thin film 11 by bringing a solvent that does not dissolve materials constituting a matrix portion in the thin film 11 but dissolves the fine particles, into contact with the thin film 11 containing fine particles to dissolve the fine particles in the solvent. Furthermore, for example, a method in which the fine particles are irradiated with radiation for decomposition or sublimation, and a method in which, after exposure to light, development is carried out with a solvent.

A resin, a cured product of a heat-curable composition, and a cured product of a photocurable composition may be mentioned as the matrix in the thin film 11. When fine particles are dissolved in a solvent to remove the fine particles from the thin film 11, examples of fine particles include water-soluble inorganic or organic fine particles, acid-soluble inorganic or organic fine particles, alkali-soluble inorganic or organic fine particles, and organic fine particles of a low-molecular weight compound that is incompatible with the matrix.

When water-soluble inorganic or organic fine particles are used, the fine particles can be removed from the thin film 11 by bringing the thin film 11 containing fine particles into contact with water. When acid-soluble inorganic or organic fine particles are used, the fine particles are removed from the thin film 11 by bringing a thin film 11 containing fine particles into contact with an acidic aqueous solution. When alkali-soluble inorganic or organic fine particles are used, the fine particles can be removed from the thin film 11 by bringing a thin film 11 containing fine particles into contact with an alkaline aqueous solution. When organic fine particles formed of a low-molecular weight compound incompatible with a matrix are used, the fine particles can be removed from the thin film 11 by bringing the thin film 11 containing fine particles into contact with an organic solvent that does not dissolve a matrix but dissolves the fine particles.

Among the above methods, a method in which a precursor film for a thin film 11, the precursor film being formed of a photosensitive composition, is position-selectively exposed and then developed is preferred, because a first pore portion 12 comprising pores having a closely regulated opening diameter can easily be formed in a short period of time. In this case, a negative-type photosensitive composition curable by exposure is preferred as a photosensitive composition for the formation of the thin film 11, from the viewpoint of forming a thin film having a high strength.

### [Support film]

The support film 13 comprises the second pore portion 14, and the thickness of the support film 13 is 1 to 100 µm. The laminated film 10 has the strength high enough to withstand the pressure applied during the filtration through by virtue of the support of the thin film 11 by the support film 13 having a thickness of 1 to 100 µm. The thickness of the support film is preferably 10 to 100 µm, from the viewpoint of a balance between the filtration cap
ability and the strength of the laminated film 10.

The opening ratio of the support film 13 is not particularly limited as long as the object of the present invention is not sacrificed. In order to meet the above relationship between the first pore portion 12 and the second pore portion 14, the opening ratio of the support film 13 is typically higher than that of the thin film 11.

As described above, the support film 13 comprises a second pore portion 14 having one or more pores that extend through the support film 13 in a thickness direction of the support film 13.

The support film 13 comprising a second pore portion 14 can be formed in the same manner as described above in connection with the thin film 11. As with the method for the formation of the thin film 11, a method is preferably adopted for the formation of the support film 13 in which a precursor film for a support film 13, the precursor film being formed of a photosensitive composition, is position-selectively exposed and then developed. As with the material for the thin film 11, the material for the support film 13 is preferably a negative-type photosensitive composition, because various photosensitive compositions can be used, making it possible to form a support film having a high strength.

The shape of the opening in the pores constituting the second pore portion 14 is not particularly limited and can be selected from various shapes as with the shape of the opening of pores constituting the first pore portion 12 in the thin film 10.

An example of a preferred combination of the thin film 11 with the support film 13 is a combination of a thin film 11 comprising a first pore portion 12 in a hole pattern having circular openings with a support film 13 comprising a second pore portion 14 in a hole pattern having circular openings, wherein the first pore portion 12 and the second pore portion 14 are arranged so that, when the laminated film 10 is observed from a direction perpendicular to a surface direction, the holes constituting the first pore portion 12 are included inside the respective holes constituting the second pore portion 14.

### <<Method for manufacturing laminated film>>

Any method for manufacturing a laminated film may be used for the manufacture of the laminated film 10 as long as a thin film 11, a support film 13, a first pore portion 12, and a second pore portion 14 that meet respective requirements can be formed.

The laminated film 10 can be formed a method in which a thin film 11 and a support film 13 that have been prepared separately from each other are stacked on top of each other, or a method in which, after the preparation of a thin film 11 or a support film 13, the other film is stacked on the thin film 11 or the support film 13. A method is more preferably adopted in which, after the preparation of a thin film 11 or a support film 13, the other film is stacked on the thin film 11 or the support 13, from the viewpoint of easiness of registration of the first pore portion 12 with the second pore portion 14.

As described above, the thin film 11 and the support film 13 are preferably formed using a negative-type photosensitive composition.

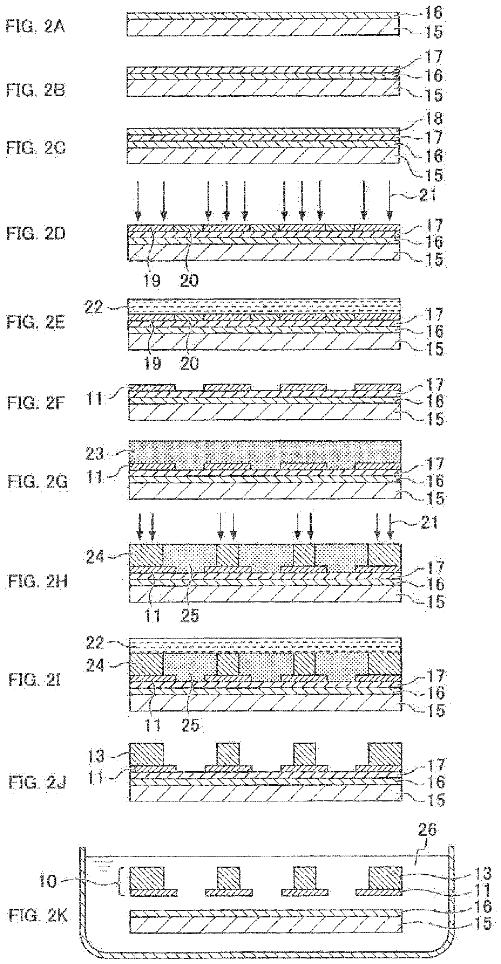

Regarding the method for manufacturing the laminated film 10, a preferred embodiment in which a thin film 11 and a support film 13 each formed using a negative-type photosensitive composition are stacked on a support through a sacrificial film will be described with reference to Figs. 2A to 2K.

In the following method, the thin film 11 is formed on a surface of a substrate 15 through a sacrificial film 17 formed of a material that is dissolvable in a liquid. The material for the substrate 15 is not particularly limited as the material is not attacked by an organic solvent contained in the photosensitive composition and a liquid for the dissolution of the sacrificial film 17. Examples of materials for the substrate 15 include silicon, glass, and PET films.

Further, an inorganic and/or organic antireflection film 16 may be provided on the surface of the substrate 15. When the thin film 11 is formed after the provision of the antireflection film 16, a first pore portion 12 having a desired diameter and shape can easily be formed by photolithography.

The inorganic antireflection film 16 can be formed, for example, by coating an inorganic antireflection film composition such as a silicon material on a substrate and firing the coating.

The organic antireflection film 16 can be formed, for example, by coating a material for organic film formation, prepared by dissolving a resin component and the like for constituting the antireflection film 16 in an organic solvent, on a substrate 15 with a spinner or the like, and baking the coating by heating, preferably at 100 to 300 °C preferably for 30 to 300 sec, more preferably for 60 to 180 sec.

The antireflection film 16 is an organic antireflection film 16. Examples of materials for the formation of the organic antireflection film include ARC series manufactured by Brewer Science Inc., AR series manufactured by Rohm and Haas Ltd., and SWK series manufactured by Tokyo Ohka Kogyo Co., Ltd.

The photosensitive composition for the formation of the thin film 11, when exposed, is cured. The photosensitive composition is not particularly limited as long as, in the step of forming the thin film that will be described later, a thin film 11 comprising a first pore portion 12 that meets predetermined size, shape and number-of-pores requirements can be formed by subjecting a precursor film 18 for a thin film, the precursor film 18 being formed of a photosensitive composition, to exposure and development, and can be properly selected from negative-type photosensitive compositions that have hitherto been known.

Examples of suitable photosensitive compositions include a composition comprising an epoxy group-containing epoxy compound and a photosensitive curing agent, a composition comprising an alkali-soluble resin, a photopolymerizable compound containing an unsaturated double bond, and a photopolymerization initiator, and a composition an alkali-soluble resin such as polyhydroxystyrene (PHS), a crosslinking agent, and a photo-acid-generating agent. Among the photosensitive compositions, a composition comprising an epoxy group-containing epoxy compound and a photosensitive curing agent and a composition comprising an alkali-soluble resin, a crosslinking agent, and a photo-acid-generating agent are preferred from the viewpoint of the strength of the formed thin film 11.

As illustrated in Figs. 2A and 2B, if necessary, an antireflection film 16 is formed on a substrate 15 described above, followed by the formation of a sacrificial film 17. Any method for manufacturing a sacrificial film 17 may be used without particular limitation. Preferably, however, a method is adopted in which a coating liquid for sacrificial film formation is coated on a substrate 15. Examples of methods for coating a liquid material for sacrificial film formation on the substrate 15 include methods that use contact transfer-type coating devices such as roll coaters, reverse coaters, and bar coaters and noncontact-type coating devices such as spinners (rotatory coating devices) and curtain flow coaters. The coating film formed after coting is then dried by heating or the like to form a sacrificial film 17. The thickness of the sacrificial film 17 is not particularly limited but is preferably 0.1 to 100 µm, more preferably 0.5 to 50 µm, particularly preferably 0.5 to 10 µm.

Materials for the sacrificial film 17 include polyvinyl alcohol resins, dextrins, gelatins, glues, caseins, shellacs, gum arabics, starches, proteins, polyacrylic acid amides, sodium polyacrylates, polyvinyl methyl ethers, styrenic elastomers, copolymers of methyl vinyl ether with maleic anhydride, copolymers of vinyl acetate with itaconic acid, polyvinyl pyrrolidones, acetylcelluloses, hydroxyethylcelluloses, and sodium alginate. These materials may be a combination of a plurality of materials soluble in liquids of the same type. The material for the sacrificial film 17 may contain rubber components such as mannan, xanthan gum, and guar gum from the viewpoints of strength and flexibility of the sacrificial film 17.

The material for the sacrificial film 17 as described above is dissolved in a liquid capable of dissolving the sacrificial film 17 to prepare a coating liquid for sacrificial film formation. The liquid that dissolves the sacrificial film 17 is not particularly limited as long as the liquid does not deteriorate or dissolve the thin film 11 and the support film 13. Examples of liquids that dissolve the sacrificial film 17 include water, acidic or basic water-soluble solutions, organic solvents, and aqueous organic solvent solutions. Among them, water, aqueous acidic or basic solutions, and aqueous organic solvent solutions are preferred.

Examples of suitable liquids that dissolve the material for the sacrificial film 17 include organic solvents. Examples of organic solvents include lactones, ketones, polyhydric alcohols, cyclic ether and ester organic solvents, aromatic organic solvents, alcoholic solvents, terpenic solvents, hydrocarbon solvents, and petroleum solvents. A single organic solvent or a combination of a plurality of types of organic solvents may be used.

Lactones as the organic solvent include γ-butyrolactone. Ketones as the organic solvents acetone, methyl ethyl ketone, cycloheptanone, cyclohexanone, methyl-n-pentyl ketone, methyl isopentyl ketone, or 2-heptanone. Polyhydric alcohols as the organic solvent include ethylene glycol, diethylene glycol, propylene glycol of dipropylene glycol.

Polyhydric alcohols as the organic solvent may also be derivatives of polyhydric alcohols, and examples thereof include compounds containing an ester bond (for example, ethylene glycol monoacetate, diethylene glycol monoacetate, propylene glycol monoacetate, or dipropylene glycol monoacetate) or compounds containing an ether bond (monoalkyl ethers or monophenyl ethers such as monomethyl ethers, monoethyl ethers, monopropyl ethers, or monobutyl ethers). Among them, propylene glycol monomethyl ether acetate (PGMEA) and propylene glycol monomethyl ether (PGME) are preferred.

Examples of cyclic ethers as the organic solvent include dioxane, and examples of esters as the organic solvent include methyl lactate, ethyl lactate (EL), methyl acetate, ethyl acetate, butyl acetate, methyl pyrubate, ethyl pyrubate, methyl methoxypropionate, or ethyl ethoxypropionate.

Aromatic organic solvents include anisole, ethyl benzyl ether, cresyl methyl ether, diphenyl ether, dibenzyl ether, phenetol, butyl phenyl ether, ethylbenzene, diethylbenzene, pentylbenzene, isopropylbenzene, toluene, xylene, cymene, or mesitylene.

The alcoholic solvent is not particularly limited as long as the solvent can dissolve the sacrificial film 17, and examples thereof include methanol and ethanol.

Examples of terpenic solvents include geraniol, nerol, linalool, citral, citronellol, menthol, isomenthol, neomenthol, α-terpineol, β-terpineol, γ-terpineol, terpinen-1-ol, terpinen-4-ol, dihydroterpinyl acetate, 1,4-cineol, 1,8-cineol, borneol, carvone, ionone, thujone, and camphor.

Hydrocarbon solvents include linear, branched, or cyclic hydrocarbons. Hydrocarbon solvents include, for example, linear hydrocarbons having 3 to 15 carbon atoms such as hexane, heptane, octane, nonane, decane, undecane, dodecane, and tridecane; branched hydrocarbons having 4 to 15 carbon atoms such as methyloctane; and cyclic hydrocarbons such as p-menthane, o-menthane, m-menthane, diphenylmenthane, 1,4-terpine, 1,8-terpine, bornane, norbornane, pinane, thujane, kalan, longifolene, α-terpinene, β-terpinene, γ-terpinene, α-pinene, β-pinene, α-thujone, and β-thujone.

Further, examples of petroleum solvents include cyclohexane, cycloheptane, cyclooctane, naphthalene, decahydronaphthalene (decaline), and tetrahydronaphthalene (tetralin).

As illustrated in Fig. 2C, a liquid photosensitive composition is coated on a surface of the formed sacrificial film 17 to form a precursor film 18 for a thin film. The photosensitive composition can be formed on the surface of the sacrificial film 17 by the same method as used in the method for coating the coating liquid for sacrificial film formation on the substrate 15 or the surface of the antireflection film 16. The thickness of the precursor film 18 for the thin film is properly regulated so that a thin film 11 having a thickness of 1 nm to 1 µm is formed.

### [Thin film formation step]

In the thin film formation step, after position-selective exposure of the precursor film 18 for a thin film, the exposed film is developed to form a thin film 11 that has a thickness of 1 to 1000 nm and comprises a first pore portion 12 having one or more pores that extends through the thin film 11 in a thickness direction.

Any method may be adopted for position-selective exposure of the surface of the precursor film 18 for a thin film, and exposure through a mask for a negative-type photosensitive composition may be mentioned as an example of the method. As illustrated in Fig. 2D, exposed areas 19 and unexposed areas 20 are formed inside the precursor film 18 for a thin film through position-selective irradiation of the surface of the precursor film 18 for a thin film with exposure light 21.

When the substrate 15 is formed of a transparent material such as a glass substrate, a method may also be adopted in which the precursor film 18 for a thin film is exposed through a surface of the substrate 15 remote from the surface of the substrate 15 with the sacrificial film 17 and the precursor film 18 for a thin film formed thereon.

As illustrated in Figs. 2E and 2F, a thin film 11 is formed by bringing the exposed precursor film 18 for a thin film into contact with a developing solution 22 for development to dissolve and remove the unexposed areas 20. The developing solution 22 is properly selected depending upon the type of the photosensitive composition. Typically, developing solutions formed of organic solvents and alkaline developing solutions are preferred.

Organic solvents usable as the developing solution 22 include polar solvents such as ketone solvents, ester solvents, ether solvents, and amide solvents, and hydrocarbon solvents.

Alkaline developing solutions include, for example, aqueous solutions of alkalis such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, dimethylethanolamine, triethanolamine, tetramethylammonium hydroxide, tetraethylammonium hydroxide, pyrrole, piperidine, 1,8-diazabicyclo[5,4,0]-7-undecene, and 1,5-diazabicyclo[4,3,0]-5-nonane. Further, the aqueous solutions prepared by adding suitable amounts of water-soluble organic solvents such as methanol or ethanol or surfactants may also be used as the alkaline developing solution.

The development time may vary depending, for example, upon the composition and thickness of the precursor film 18 for a thin film and is generally 1 to 30 min. The development may be carried out by a method selected from publicly known methods, and any of a liquid filling-up method, a dipping method, a paddle method, a spray development method and the like may be used.

### [Support film formation step]

In the support film formation step, as illustrated in Fig. 2G, at the outset, a negative-type photosensitive composition for support film formation is coated on a surface of a thin film 11 to form a precursor film 23 for a support film. At that time, the negative-type photosensitive composition is coated on a surface of the thin film 11 so as to be filled into the first pore portion 12 in the thin film 11. Coating in the formation of the precursor film 23 for a support film may be carried out by the same method as the coating method for the formation of the precursor film 18 for a thin film. The thickness of the precursor film 23 for a support film is properly regulated so that a support film 13 having a thickness of 1 to 100 µm is formed.

Subsequently, as illustrated in Fig. 2H, exposed areas 24 and unexposed areas 25 are formed inside the precursor film 23 for a support film by exposure of the precursor film 23 for a support film in the same manner as exposure of the precursor film 18 for a thin film.

After exposure, as illustrated in Figs. 2I and 2J, when development is carried out with a developing solution 22 in the same manner as in the thin film formation step, the unexposed areas 25 are dissolved and removed to form a support film 13.

In this case, typically, as illustrated in Fig. 2H, exposure and development are carried out so that openings in the first pore portion 12 in the thin film 11 are included inside openings in the second pore portion 14 in the support film 13.

After the formation of the support film 13, as illustrated in Fig. 2K, a substrate 15 equipped with a laminated film 10 comprising a thin film 11 and a support film 13 is brought into contact with a dissolving liquid 26 capable of dissolving the sacrificial film 17 to dissolve the sacrificial film 17. By doing so, the laminated film 10 can be separated from the surface of the substrate 15.

Any method can be used for the dissolution of the sacrificial film 17 without particular limitation. As illustrated in Fig. 2K, however, a method is preferably adopted in which a substrate 15 equipped with a sacrificial film 17 and a laminated film 10 is immersed in a dissolving liquid 26 contained in a vessel.

Various liquids capable of dissolving the material for the sacrificial film 17 described in connection with the photosensitive composition film formation step may be used as the dissolving liquid 26 that dissolves the sacrificial film 17.

The laminated film according to the invention of the present application thus formed simultaneously has the strength high enough to withstand the pressure applied during the filtration and a good filtration rate and thus is suitable as filters for the filtration of various fluids.

### EXAMPLES

The present invention will be described in more detail with reference to Examples. The present invention, however, should not be construed to be limited to these Examples.

### [Example 1]

An organic material for an antireflection film (SWK-T7LE, manufactured by Tokyo Ohka Kogyo Co., Ltd.) was coated on an 8-inch silicon wafer, followed by baking under conditions of 180 °C and 90 sec to form an antireflection film having a thickness of 0.16 µm. Subsequently, a solution (solid content: 10% by mass) prepared by dissolving a thermoplastic elastomer that is a hydrogenated styrene-isoprene copolymer and has the following structure in decahydronaphthalene was coated on the antireflection film, followed by baking under conditions of 90 °C and 5 min and under conditions of 120 °C and 5 min to form sacrificial films having a thickness of 1.5 µm.

### (Hydrogenated styrene-isoprene copolymer)

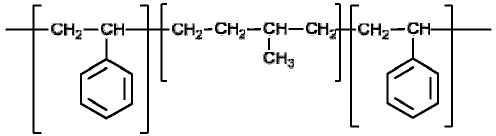

Subsequently, a negative-type photosensitive composition (TSMR-iN027PM, manufactured by Tokyo Ohka Kogyo Co., Ltd.) was coated on the sacrificial film. The coating film of the negative-type photosensitive composition was exposed under conditions of NA=0.57 and σ=0.56 through a photomask having a predetermined pattern with an exposure device (Nikon i14E, manufactured by NIKON CORPORATION), followed by paddle development with a 2.38% by mass aqueous tetramethylammonium hydroxide solution for 30 sec. After the development, the film was baked at 100 °C for 60 sec to form a 1 µm-thick thin film that has regularly arranged pores of circular openings having a diameter of 600 nm and has an opening ratio of 25%.

A cationically polymerizable negative-type photosensitive composition containing a polyfunctional epoxy resin (TMMR-S2000, manufactured by Tokyo Ohka Kogyo Co., Ltd.) was coated on the formed thin film to form a precursor film for a support film. The precursor film for the support film was exposed and developed to form, on the thin film, a 10 µm-thick support film that has regularly arranged pores of circular openings having a diameter of 10 µm and has an opening ratio of 40%.

Subsequently, the substrate comprising a laminated film of the thin film and the support film stacked on top of each other was immersed in p-menthane at room temperature for one hour to dissolve the sacrificial film and to separate the laminated film from the substrate. The separated laminated film was recovered and was then rinsed with ion-exchange water and then dried.

The laminated film thus obtained was mounted on a filter holder for vacuum filtration, and a liquid feed test was carried out at a degree of vacuum of -0.1 MPa with a filtration area specified by a teflon (registered trademark) O-ring having a diameter of 5 mm. As a result, the filtration rate was 10.5 mL/min.

### [Comparative Example 1]

A liquid feed test was carried out in the same manner as in Example 1, except that a commercially available polycarbonate membrane filter (K080A, manufactured by Advantec Co., Ltd.) was used, the filter having many pores that extend through the membrane in a thickness direction, the pores having an average opening diameter of 0.8 µm, a membrane thickness of 9 µm, and a pore density of 3×10⁷ pores/cm². As a result, the filtration rate was 2.1 mL/min.

### [Comparative Example 2]

A laminated film was obtained in the same manner as in Example 1, except that the opening ratio of the thin film was changed to 85% and the opening ratio of the support film was changed to 35%.

A liquid feed test was carried out in the same manner as in Example 1, except that the laminated film thus obtained was used. As a result, breaking of the laminated film occurred.

### EXPLANATION OF REFERENCE NUMERALS

10: laminated film
11: thin film
12: first pore portion
13: support film
14: second pore portion
15: substrate
16: antireflection film
17: sacrificial film
18: precursor film for thin film
19: exposed area
20: unexposed area
21: exposure light
22: developing solution
23: precursor film for support film
24: exposed area
25: unexposed area
26: dissolving solution

## Claims

1. A laminated film (10) comprising a thin film (11) and a support film (13) stacked on top of each other,
the thin film (11) comprises a first pore portion (12) having one or more pores that extend through the thin film (11) in a thickness direction,
the support film (13) comprises a second pore portion (14) having one or more pores that are extended through the support film (13) in a thickness direction,
at least a part of the pores constituting the first pore portion (12) is in communication with at least a part of the pores constituting the second pore portion (14),
**characterized in that** the thin film (11) has a thickness of 1 nm to 1 µm,
the thin film (11) has an opening ratio of not more than 80%,
the pore in the thin film (11) has an aspect ratio A/B of not more than 2 wherein A represents a thickness of the thin film (11); and B represents an average value of the width of the openings in the one or more pores possessed by the thin film (11), and
the support film (13) has a thickness of 1 to 100µm, and
all the openings of the pores constituting the first pore portion (12) are included respectively within the openings of the pores constituting the second pore portion (14).

2. The laminated film (10) according to claim 1, wherein, for the thin film (11), B is not more than 1 µm, the thin film (11) has an opening ratio of not more than 40%, and the aspect ratio of the first pore portion (12) in the thin film (11) is not more than 1.

3. The laminated film (10) according to claim 1 or 2, wherein each of the thin film (11) and the support film (13) has been formed by photolithography using a photosensitive composition.

4. The laminated film (10) according to any one of claims 1 to 3, wherein the first pore portion (12) and the second pore portion (14) have circular openings.

5. The laminated film (10) according to any one of claims 1 to 4, wherein when the laminated film (10) is observed in a direction perpendicular to a surface direction, the proportion of the total of areas of openings of the first pore portion (12) overlapped with openings in the second pore portion (14) to the total area of the openings of the first pore portion (12) is 100%.

## Patentansprüche

1. Laminierter Film (10), umfassend einen Dünnfilm (11) und einen Stützfilm (13), die übereinander angeordnet sind,
wobei der Dünnfilm (11) einen ersten Porenabschnitt (12) umfasst, der eine oder mehrere Poren aufweist, welche sich durch den Dünnfilm (11) in einer Dickenrichtung erstrecken,
wobei der Stützfilm (13) einen zweiten Porenabschnitt (14) umfasst, welcher eine oder mehrere Poren aufweist, die sich durch den Stützfilm (13) in einer Dickenrichtung erstrecken,
wobei mindestens ein Teil der Poren, die den ersten Porenabschnitt (12) bilden, in Kommunikation mit mindestens einem Teil der Poren, die den zweiten Porenabschnitt (14) bilden, steht,
**dadurch gekennzeichnet, dass** der Dünnfilm (11) eine Dicke von 1 nm bis 1 µm aufweist,
der Dünnfilm (11) ein Öffnungsverhältnis von nicht mehr als 80 % aufweist, die Pore in dem Dünnfilm (11) ein Aspektverhältnis A/B von nicht mehr als 2 aufweist, wobei A eine Dicke des Dünnfilms (11) darstellt; und B einen Durchschnittswert der Breite der Öffnungen in der einen oder den mehreren Poren darstellt, die der Dünnfilm (11) innehat, und
der Stützfilm (13) eine Dicke von 1 bis 100 µm aufweist, und all die Öffnungen der Poren, die den ersten Porenabschnitt (12) darstellen entsprechend innerhalb der Öffnungen der Poren umfasst sind, die den zweiten Porenabschnitt (14) darstellen.

2. Laminierter Film (10) nach Anspruch 1, wobei, für den Dünnfilm (11), B nicht mehr als 1 µm ist, der Dünnfilm (11) ein Öffnungsverhältnis von nicht mehr als 40 % aufweist und das Aspektverhältnis des ersten Porenabschnitts (12) in dem Dünnfilm (11) nicht mehr als 1 ist.

3. Laminierter Film (10) nach Anspruch 1 oder 2, wobei jeder des Dünnfilms (11) und des Stützfilms (13) durch Photolitographie unter Verwendung einer photosensitiven Zusammensetzung gebildet wurde.

4. Laminierter Film (10) nach einem der Ansprüche 1 bis 3, wobei der erste Porenabschnitt (12) und der zweite Porenabschnitt (14) kreisförmige Öffnungen aufweisen.

5. Laminierter Film (10) nach einem der Ansprüche 1 bis 4, wobei, wenn der laminierte Film (10) in einer Richtung senkrecht zu einer Oberflächenrichtung betrachtet wird, der Anteil der Gesamtheit von Flächen von Öffnungen von dem ersten Porenabschnitt (12), überlappend mit Öffnungen in dem zweiten Porenabschnitt (14), zu der Gesamtfläche der Öffnungen des ersten Porenabschnitts (12) 100 % ist.

## Revendications

1. Film stratifié (10) comprenant un film mince (11) et un film support (13) empilés l'un sur l'autre,
le film mince (11) comprend une première partie de pores (12) présentant un ou plusieurs pores qui s'étendent à travers le film mince (11) dans une direction de l'épaisseur,
le film support (13) comprend une seconde partie de pores (14) présentant un ou plusieurs pores qui s'étendent à travers le film support (13) dans une direction de l'épaisseur,
au moins une partie des pores constituant la première partie de pores (12) est en communication avec au moins une partie des pores constituant la seconde partie de pores (14),
**caractérisé en ce que** le film mince (11) présente une épaisseur de 1 nm à 1 µm,
le film mince (11) présente un rapport d'ouverture de pas plus de 80 %,
le pore dans le film mince (11) présente un rapport de dimension A/B de pas plus de 2 dans lequel A représente une épaisseur du film mince (11) ; et B représente une valeur moyenne de la largeur des ouvertures dans les un ou plusieurs pores que possède le film mince (11), et
le film support (13) présente une épaisseur de 1 à 100 µm, et
toutes les ouvertures des pores constituant la première partie de pores (12) sont incluses respectivement dans les ouvertures des pores constituant la seconde partie de pores (14).

2. Film stratifié (10) selon la revendication 1, dans lequel, pour le film mince (11), B n'est pas plus de 1 µm, le film mince (11) présente un rapport d'ouverture de pas plus de 40 %, et le rapport de dimension de la première partie de pores (12) dans le film mince (12) n'est pas plus de 1.

3. Film stratifié (10) selon la revendication 1 ou 2, dans lequel chacun du film mince (11) et du film support (13) a été formé par photolithographie en utilisant une composition photosensible.

4. Film stratifié (10) selon l'une quelconque des revendications 1 à 3, dans lequel la première partie de pores (12) et la seconde partie de pores (14) présentent des ouvertures circulaires.

5. Film stratifié (10) selon l'une quelconque des revendications 1 à 4, dans lequel lorsque le film stratifié (10) est observé dans une direction perpendiculaire à une direction de la surface, la proportion du total des aires d'ouvertures de la première partie de pores (12) chevauchées par des ouvertures dans la seconde partie de pores (14) par rapport à l'aire totale des ouvertures de la première partie de pores (12) est de 100 %.
